# FASCICULE DE BREVET EUROPEEN

(11) **EP 2 929 079 B1**
(45) Date de publication et mention de la délivrance du brevet: **18.01.2017**
(21) Numéro de dépôt: 13795235.4
(22) Date de dépôt: 22.11.2013
(51) Int. Cl.: D06F 75/38, C23C 4/10

(54) **SEMELLE DE FER A REPASSER PRESENTANT DES PROPRIETES DE GLISSE ET DE RESISTANCE A L'ABRASION AMELIOREES**
BÜGELEISENSOHLE MIT VERBESSERTEN GLEIT- UND REIBWIDERSTANDSEIGENSCHAFTEN
SOLE OF AN IRON WITH IMPROVED SLIDING AND ABRASION RESISTANCE PROPERTIES

(30) Priorité: 26.11.2012 FR 1261227
(43) Date de publication de la demande: 14.10.2015
(73) Titulaire: SEB S.A., 69130 Ecully (FR); Université de Lorraine, 54052 Nancy Cedex (FR); CNRS - Centre National de la Recherche Scientifique (EPST), 75794 Paris Cedex 16 (FR)
(72) Inventeur: ALLEMAND, Simon, 74150 Rumilly (FR); PACCAUD, Denis, 69008 Lyon (FR); TUFFE, Stéphane, 73160 Cognin (FR); PIERSON, Jean-François, 88450 Vincey (FR)
(74) Mandataire: Cémeli, Eric Philippe Laurent
(86) Numéro de dépôt international: PCT/EP2013/074506
(87) Numéro de publication internationale: WO 2014/079982

(56) Documents cités:
- DE-A1- 19 909 887
- US-A- 4 665 637
- US-B2- 6 895 700

## Description

La présente invention concerne le domaine technique des fers à repasser.

La présente invention se rapporte plus particulièrement aux semelles de fer à repasser ainsi qu'à leurs procédés d'obtention.

Les semelles de fer à repasser comportant un revêtement de type émail présentent de bonnes propriétés de glisse et de résistance à l'abrasion mais ont l'inconvénient d'être sensibles aux chocs ainsi qu'à l'écaillage.

Les semelles de fer à repasser en acier inoxydable sont plus résistantes aux chocs et ne sont pas concernées par l'écaillage. Ces semelles présentent toutefois des propriétés de glisse et de résistance à l'abrasion moins bonnes. Des microrayures peuvent notamment apparaitre sur les semelles en acier inoxydable.

Une semelle de fer à repasser divulguant las caractéristiques du préambule de la revendication 1 est connue de US 4 665 637 A.

Un objet de la présente invention est de proposer une semelle de fer à repasser peu sensible aux chocs, qui présente des propriétés de glisse améliorées par rapport aux semelles en acier inoxydable.

Un autre objet de la présente invention est de proposer une semelle de fer à repasser peu sensible aux chocs, qui présente des propriétés de résistance à la microrayure et/ou à l'abrasion améliorées par rapport aux semelles en acier inoxydable.

Un autre objet de la présente invention est de proposer un fer à repasser comportant une semelle peu sensible aux chocs, qui présente des propriétés de glisse améliorées par rapport aux semelles en acier inoxydable.

Un autre objet de la présente invention est de proposer un fer à repasser comportant une semelle peu sensible aux chocs, qui présente des propriétés de résistance à la microrayure et/ou à l'abrasion améliorées par rapport aux semelles en acier inoxydable.

Un autre objet de la présente invention est de proposer un procédé d'obtention d'une semelle de fer à repasser peu sensible aux chocs, qui présente des propriétés de glisse améliorées par rapport aux semelles en acier inoxydable.

Un autre objet de la présente invention est de proposer un procédé d'obtention d'une semelle de fer à repasser peu sensible aux chocs, qui présente des propriétés de résistance à la microrayure et/ou à l'abrasion améliorées par rapport aux semelles en acier inoxydable.

Ces objets sont atteints avec une semelle de fer à repasser comportant un corps de semelle métallique présentant une surface de glisse céramique prévue pour le repassage, du fait que le corps de semelle présente une dureté supérieure ou égale à 150 HV et forme un substrat portant une couche superficielle de borure ou de boronitrure de métal de transition formant la surface de glisse. Les couches superficielles de borures de métaux de transition sont connues pour leurs propriétés de grande dureté, de résistance à l'usure et leur stabilité thermique. Des essais ont montré que de manière surprenante de telles couches superficielles présentent également des propriétés de glisse améliorées par rapport aux semelles en acier inoxydable. Les propriétés de dureté du substrat permettent également d'améliorer la résistance à la microrayure et/ou à l'abrasion ainsi que la résistance aux chocs de la couche superficielle de borure ou de boronitrure de métal de transition.

En d'autres termes, le corps de semelle forme un substrat portant une couche superficielle de borure de métal de transition ou de boronitrure de métal de transition formant la surface de glisse.

Avantageusement, le corps de semelle présente un coefficient de dilatation thermique inférieur à 20.10⁻⁶ K⁻¹. Ces dispositions permettent d'améliorer les propriétés de glisse en évitant les phénomènes de fissuration de la couche superficielle de borure ou de boronitrure de métal de transition.

Selon une forme de réalisation préférée, le corps de semelle est réalisé en acier inoxydable ou en titane. Si désiré, un corps de semelle multimatériaux, notamment un corps de semelle multicouches et/ou composite à matrice métallique, pourrait être envisagé.

Selon un mode de réalisation, la couche superficielle est formée par un revêtement de borure ou de boronitrure de métal de transition. De manière avantageuse, l'épaisseur de la couche superficielle est alors comprise entre 0,1 et 5 µm.

En d'autres termes, la couche superficielle est formée par un revêtement de borure de métal de transition ou de boronitrure de métal de transition.

Avantageusement alors, le métal de transition est choisi parmi le titane, le chrome, le zirconium, le vanadium, le niobium, le fer.

Selon un autre mode de réalisation, la couche superficielle est formée par une couche de conversion de borure de fer et/ou de titane, selon le matériau utilisé pour le corps de semelle. De manière avantageuse, l'épaisseur de la couche superficielle est alors comprise entre 10 et 300 µm.

Ces objets sont atteints également avec un fer à repasser comportant une semelle associée à un corps de chauffe comprenant des moyens électriques de chauffe, dans lequel la semelle est conforme à l'une au moins des caractéristiques précitées.

Selon une forme de réalisation avantageuse, la semelle comporte des orifices prévus pour le passage de vapeur.

Alors, selon un mode de réalisation, le fer à repasser comporte un générateur de vapeur interne relié aux orifices prévus pour le passage de la vapeur.

Alors, selon un autre mode de réalisation, le fer à repasser est associé à un générateur de vapeur externe relié aux orifices prévus pour le passage de la vapeur.

Ces objets sont atteints également avec un procédé d'obtention d'une semelle de fer à repasser, comprenant les étapes suivantes :
- fourniture ou réalisation d'un corps de semelle métallique présentant une dureté supérieure ou égale à 150 HV,
- réalisation d'une couche superficielle de borure ou de boronitrure de métal de transition sur la face externe du corps de semelle, pour former une surface de glisse.

En d'autres termes, ces objets sont atteints également avec un procédé d'obtention d'une semelle de fer à repasser, comprenant les étapes suivantes :
- fourniture ou réalisation d'un corps de semelle métallique présentant une dureté supérieure ou égale à 150 HV,
- réalisation d'une couche superficielle de borure de métal de transition ou de boronitrure de métal de transition sur la face externe du corps de semelle, pour former une surface de glisse.

Avantageusement, le corps de semelle présente un coefficient de dilatation thermique inférieur à 20.10⁻⁶ K⁻¹.

Avantageusement alors, le corps de semelle est réalisé en acier inoxydable ou en titane.

Selon un mode de réalisation, le procédé consiste à réaliser un revêtement de borure ou de boronitrure de métal de transition sur la face externe du corps de semelle, pour former la surface de glisse.

En d'autres termes, le procédé consiste à réaliser un revêtement de borure de métal de transition ou de boronitrure de métal de transition sur la face externe du corps de semelle, pour former la surface de glisse.

Avantageusement alors, le métal de transition est choisi parmi le titane, le chrome, le zirconium, le vanadium, le niobium, le fer.

Selon une forme de réalisation, le revêtement est réalisé par dépôt physique en phase vapeur sur la face externe du corps de semelle.

Alors, selon une forme de réalisation préférée permettant d'obtenir des dépôts denses adhérant au substrat, le dépôt est réalisé par pulvérisation cathodique magnétron à courant continu, de préférence à courant continu pulsé.

En alternative, le revêtement pourrait notamment être réalisé par évaporation par arc cathodique sur la face externe du corps de semelle.

Selon une autre forme de réalisation, le revêtement est réalisé par dépôt chimique en phase vapeur assistée plasma sur la face externe du corps de semelle.

Selon un autre mode de réalisation, le procédé consiste à réaliser une couche de conversion de borure de fer ou de titane par traitement de diffusion thermochimique de boruration sur la face externe du corps de semelle, pour former la surface de glisse.

L'invention sera mieux comprise à l'étude de deux modes de réalisation, pris à titre nullement limitatif, illustrés dans les figures annexées, dans lesquelles :
- la figure 1 est une vue schématique de dessous d'une semelle de fer à repasser,
- la figure 2 est une vue schématique de dessous d'une semelle de fer à repasser à vapeur,
- la figure 3 est une vue schématique en coupe d'une semelle de fer à repasser associée à un corps de chauffe,
- la figure 4 est une vue schématique d'un fer à repasser comportant un générateur de vapeur interne,
- la figure 5 est une vue schématique d'un fer à repasser associé à un générateur de vapeur externe,
- la figure 6 est une vue schématique en coupe d'un premier mode de réalisation d'une semelle de fer selon l'invention,
- la figure 7 est une vue schématique en coupe d'un deuxième mode de réalisation d'une semelle de fer selon l'invention.

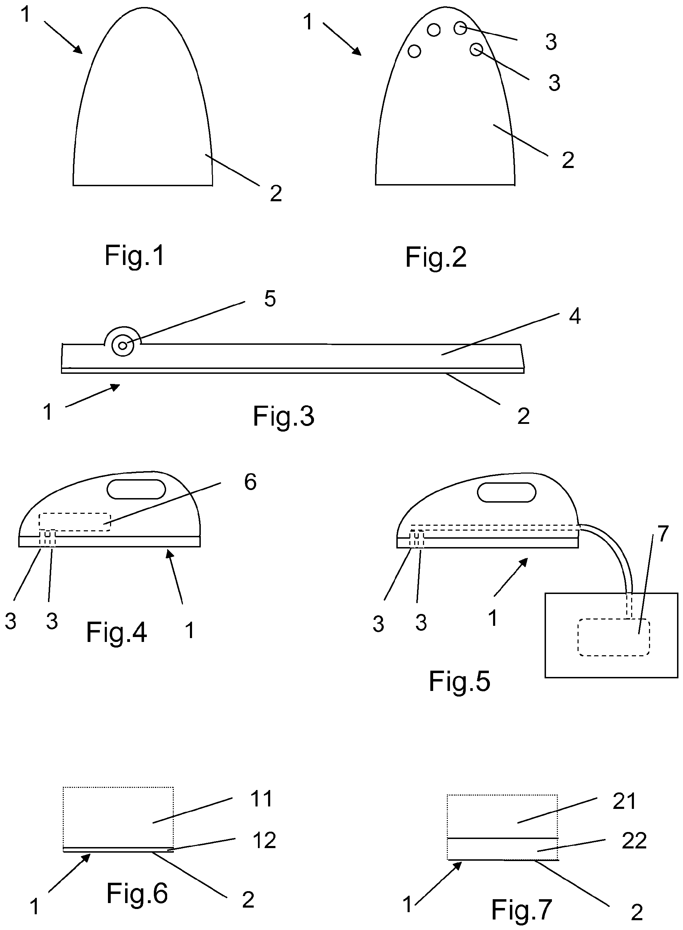

Les fers à repasser comprennent une semelle 1 comportant une surface de glisse 2 prévue pour le repassage, tel que représenté sur la figure 1. Dans les fers à repasser à vapeur, la semelle 1 comporte des orifices 3 prévus pour le passage de vapeur, tel que représenté sur la figure 2. La semelle 1 est associée à un corps de chauffe 4 comprenant des moyens électriques de chauffe 5 tel que représenté sur la figure 3, les orifices 3 n'étant pas représentés. Le corps de chauffe 4 est avantageusement réalisé en aluminium. Les moyens électriques de chauffe 5 sont avantageusement formés par un élément chauffant blindé.

Selon une première forme de réalisation illustrée sur la figure 4, le fer à repasser comporte un générateur de vapeur interne 6 relié aux orifices 3 prévus pour le passage de la vapeur. Selon une deuxième forme de réalisation illustrée sur la figure 5, le fer à repasser est associé à un générateur de vapeur externe 7 relié aux orifices 3 prévus pour le passage de la vapeur.

Tel que représenté sur les figures 6 et 7, la semelle 1 de fer à repasser comporte un corps de semelle 11, 21 métallique présentant une surface de glisse 12, 22 céramique prévue pour le repassage.

Plus particulièrement selon l'invention, le corps de semelle 11, 21 métallique forme un substrat portant une couche superficielle de borure ou de boronitrure de métal de transition formant la surface de glisse 12, 22.

L'expression « borure de métal de transition » n'est pas limitée aux compositions stoechiométriques comportant un atome de bore pour un atome de métal de transition, mais inclut notamment les diborures de métaux de transition. Le métal de transition est de préférence choisi parmi le titane, le chrome, le zirconium, le vanadium, le niobium, le fer. Les borures des métaux de transition tels que le titane, le chrome, le zirconium, le vanadium, le niobium sont des diborures. Le corps de semelle 11, 21 métallique est avantageusement réalisé en acier inoxydable ou en titane.

L'expression « boronitrure de métal de transition » n'est pas limitée aux compositions stoechiométriques comportant un atome de bore et un atome d'azote pour un atome de métal de transition, mais inclut notamment des boronitures tel que le TiAlBN.

En d'autres termes, le corps de semelle 11, 21 métallique forme un substrat portant une couche superficielle de borure de métal de transition ou de boronitrure de métal de transition formant la surface de glisse 12, 22.

L'invention concerne également les fers à repasser comportant une telle semelle 1.

Selon un premier mode de réalisation, la couche superficielle est formée par un revêtement de borure ou de boronitrure de métal de transition. Le revêtement de borure ou de boronitrure de métal de transition est déposé sur un substrat formé par le corps de semelle 11 métallique.

En d'autres termes, la couche superficielle est formée par un revêtement de borure de métal de transition ou de boronitrure de métal de transition.

Les revêtements de type borures de métaux de transition tel que TiB₂, CrB₂, FeB, Fe₂B, VB₂, NbB₂ ou ZrB₂ sont connus pour leurs propriétés de grande dureté, de résistance à l'usure et à la corrosion et leur stabilité thermique.

Plusieurs procédés permettent d'obtenir des couches minces de borures de métaux de transition tels que TiB₂, CrB₂, FeB, Fe₂B, VB₂, NbB₂ ou ZrB₂. Le revêtement peut notamment être réalisé par dépôt physique en phase vapeur sur la face externe du corps de semelle, ou par dépôt chimique en phase vapeur assistée plasma sur la face externe du corps de semelle.

Parmi les techniques de dépôt physique en phase vapeur (PVD), la pulvérisation cathodique magnétron à courant continu, pulsé ou non pulsé, semble la méthode la plus appropriée pour obtenir de tels revêtements car elle permet d'effectuer des dépôts à basse température (inférieure à 200°C) sur des pièces pouvant présenter des géométries relativement complexes sans utiliser de gaz toxique. Les dépôts obtenus sont denses et adhérents au substrat. De plus, la topographie de surface du substrat est conservée.

Les dépôts de borures de métaux de transition sont obtenus à partir d'une cible possédant la même composition que celle du revêtement visé, la cible pouvant être élaborée par frittage de poudre. Après obtention d'un vide poussé dans l'enceinte, le film est élaboré par pulvérisation en condition non-réactive sous atmosphère d'argon de la cible. Les vitesses de dépôt obtenues par cette technique sont de l'ordre de quelques µm/h.

L'épaisseur du revêtement obtenu est avantageusement comprise entre 0,1 et 5 µm.

D'autres procédés pourraient être réalisés pour obtenir des revêtements de borures de métaux de transition, tels que la pulvérisation cathodique radiofréquence, la pulvérisation cathodique en milieu réactif avec utilisation de diborane, ou encore la pulvérisation par faisceau d'ions. Toutefois, les vitesses de dépôts obtenues par ces techniques sont plus faibles qu'avec la pulvérisation cathodique magnétron.

Le revêtement pourrait aussi être réalisé par évaporation par arc cathodique sur la face externe du corps de semelle 11.

Les dépôts chimiques en phase vapeur assistée plasma peuvent également permettre l'obtention de revêtements de borures de métaux de transition à relativement basse température (de l'ordre de 400°C). Par exemple, pour une couche mince de TiB₂, les gaz utilisés sont BCl₃, TiCl₄ ou Ti(BH₄)₄. Ce procédé peut permettre ainsi l'obtention de dépôts stoechiométriques possédant des propriétés proches de ceux obtenus par PVD.

Les dépôts testés ont été élaborés par technique PVD, en utilisant une pulvérisation cathodique magnétron à courant continu pulsé d'une cible CrB₂ sous atmosphère d'argon. L'épaisseur de revêtement visée est comprise entre 0,1 et 5 µm. Le revêtement en CrB₂ obtenu est adhérent, d'une couleur quasiment identique à celle de l'acier inoxydable. L'épaisseur du revêtement déposé est de 2 µm.

A titre de variante, les dépôts peuvent être obtenus par copulvérisation d'une cible métallique X et d'une cible B₄C. (X désignant un métal de transition ou un alliage métallique de métaux de transitions tels que TiAl, TiCr, ZrNb..). La couche superficielle comporte alors des traces de carbone.

Les coefficients de glisse ont été mesurés à sec sur du coton et du polyester, selon la norme IEC 60130, en mesurant la force horizontale nécessaire pour tirer le fer à repasser reposant sur un tissu tendu, le coefficient de glisse correspondant à la force de traction divisée par le poids de l'ensemble en mouvement (fer + support). Sur du coton, une valeur de 0,12 a été obtenue pour la température de 200°C, cette valeur étant meilleure que celle d'une surface de glisse en acier inoxydable (0,22 à 0,24), et proche de celle d'une surface de glisse en émail (0,10). A 25°C, une valeur de 0,20 a été obtenue, cette valeur étant bien meilleure que celle d'une surface de glisse en émail (0,30 à 0,40). Sur du polyester, une valeur de 0,16 a été obtenue pour la température de 120°C, cette valeur étant meilleure que celle d'une surface de glisse en acier inoxydable (0,20), et meilleure que celle d'une surface de glisse en émail (0,29). A 25°C, une valeur de 0,21 a été obtenue, cette valeur étant bien meilleure que celle d'une surface de glisse en émail (0,32).

Les valeurs précitées ont été obtenues avec un dépôt réalisé sur un corps de semelle en aluminium. Il a été vérifié qu'une fissuration du revêtement apparaît lors de la chauffe si un substrat en aluminium (≈ 23. 10⁻⁶ K⁻¹) est utilisé.

Pour obtenir une surface de glisse 12 présentant de bonnes propriétés de résistance aux chocs et de résistance à la microrayure et/ou à l'abrasion, le substrat doit posséder une dureté minimale.

Les revêtements de borure de métal de transition présentent une dureté élevée (> 2000 HV), l'épaisseur de ces revêtements peut être très faible, avantageusement comprise entre 0,1 et 5 µm. Un substrat possédant une dureté minimale de 150 HV doit être utilisé afin de garantir une meilleure résistance à la microrayure et/ou à l'abrasion du revêtement, un substrat trop mou tel que l'aluminium ne permettant pas d'exploiter les propriétés de dureté et de résistance aux chocs apportées par un revêtement de borure de métal de transition. Ainsi, un substrat en acier inoxydable ferritique (≈ 160 HV), en acier inoxydable austénitique (≈ 210 HV) ou en titane (> 160 HV) peut être utilisé dans le cadre de cette invention. En revanche, un substrat en aluminium (50 à 90 HV) ne présente pas une dureté suffisante pour obtenir les propriétés souhaitées.

Ainsi le corps de semelle 11 métallique présente une dureté supérieure ou égale à 150 HV. Le corps de semelle 11 métallique est avantageusement réalisé en acier inoxydable ou en titane.

Les borures de métaux de transition possèdent des coefficients de dilatation thermiques faibles (< 10.10⁻⁶ K⁻¹). Le substrat doit ainsi posséder un coefficient de dilatation thermique proche des coefficients de dilatation des borures de métaux de transition, afin d'éliminer tout risque de fissuration lors de la chauffe de la semelle, ce qui dégraderait les propriétés de glisse du revêtement décrit dans l'invention. Un substrat métallique à faible coefficient de dilatation thermique tel que l'acier inoxydable ferritique (≈ 11. 10⁻⁶ K⁻¹), l'acier inoxydable austénitique (≈ 16. 10⁻⁶ K⁻¹), ou le titane (≈ 10. 10⁻⁶ K⁻¹) permet ainsi d'éviter ce problème de fissuration du revêtement au cours de la chauffe de la semelle.

L'utilisation d'un substrat présentant un coefficient de dilatation thermique faible permet d'éviter les phénomènes de fissuration de la surface de glisse 12. Ainsi de préférence, le corps de semelle 11 métallique présente un coefficient de dilatation thermique inférieur à 20.10⁻⁶ K⁻¹.

L'épaisseur du corps de semelle métallique est avantageusement de l'ordre de 0,4 mm.

Une semelle de fer à repasser comportant un revêtement selon l'invention présente des propriétés de glisse significativement supérieures à celle d'un acier inoxydable, et de plus une résistance à l'abrasion améliorée par rapport à une semelle en acier inoxydable.

A titre de variante, des dépôts de boronitrures de métaux de transition de type XBN, par exemple TiBN ou TiAlBN, peuvent être obtenus par plusieurs voies, par exemple soit directement à partir d'une cible XBN, la couche superficielle étant élaborée en pulvérisation en condition non réactive sous atmosphère d'argon, soit à partir d'une cible XB ou XB₂, la couche superficielle étant déposée sous condition réactive. Les boronitrures permettent d'obtenir une couleur différente de l'acier inoxydable, par exemple gris foncé ou anthracite pour le TiBN.

Selon un deuxième mode de réalisation, la couche superficielle est formée par une couche de conversion de borure de fer ou de titane. La couche de conversion est réalisée par traitement de diffusion thermochimique de boruration sur un substrat métallique formé par le corps de semelle 21.

Les traitements de diffusion thermochimiques tels que la boruration permettent d'enrichir la surface d'une pièce en bore. Ces traitements sont usuellement réalisés entre 800 et 1000°C. Des couches homogènes de borures fortement adhérentes sont ainsi formées en surface. Différents procédés peuvent être utilisés pour réaliser de tels traitements. En milieu gazeux, les gaz sources de bore sont des halogénures de bore ou des boranes. En milieu liquide, en présence de sels fondus avec ou sans électrolyse, ou en solution aqueuse de borax. En milieu solide, par méthode de type cémentation en caisse, dans laquelle les pièces sont placées dans un cément constitué par de la poudre et des granules à base de carbure de bore auquel est mélangé un fluoroborate jouant le rôle d'activateur. La température (de l'ordre de 900°C) et le temps de traitement dépendent de l'épaisseur de la zone borurée souhaitée. Typiquement, les épaisseurs de couches borurées varient entre 10 et 300 µm. Les duretés atteintes dépendent du matériau utilisé. L'une des applications les plus courantes concerne les alliages ferreux (et notamment les aciers inoxydables) dont la dureté peut atteindre de 1600 à 2000 HV. Il est également possible de réaliser un tel traitement thermochimique de boruration sur des métaux comme le titane (formation de couche de borure de titane pouvant atteindre les 4000 HV) ou d'alliages base nickel (jusqu'à 2800 HV).

Ainsi le corps de semelle 21 métallique présente une dureté supérieure ou égale à 150 HV. Le corps de semelle métallique 21 est avantageusement réalisé en acier inoxydable ou en titane.

L'invention concerne également un procédé d'obtention d'une semelle de fer à repasser, comprenant les étapes suivantes :
- fourniture ou réalisation d'un corps de semelle 11, 21 métallique présentant une dureté supérieure ou égale à 150 HV,
- réalisation d'une couche superficielle de borure ou de boronitrure de métal de transition sur la face externe du corps de semelle 11, 21, pour former une surface de glisse 12, 22.

En d'autres termes, l'invention concerne également un procédé d'obtention d'une semelle de fer à repasser, comprenant les étapes suivantes :
- fourniture ou réalisation d'un corps de semelle 11, 21 métallique présentant une dureté supérieure ou égale à 150 HV,
- réalisation d'une couche superficielle de borure de métal de transition ou de boronitrure de métal de transition sur la face externe du corps de semelle 11, 21, pour former une surface de glisse 12, 22.

Selon le premier mode de réalisation, le procédé consiste à réaliser un revêtement de borure ou de boronitrure de métal de transition sur la face externe du corps de semelle 11.

En d'autres termes, selon le premier mode de réalisation, le procédé consiste à réaliser un revêtement de borure de métal de transition ou de boronitrure de métal de transition sur la face externe du corps de semelle 11.

Selon le deuxième mode de réalisation, le procédé consiste à réaliser une couche de conversion de borure de fer ou de titane par traitement de diffusion thermochimique de boruration sur la face externe du corps de semelle 11 ; 21.

Ainsi la surface de glisse 12, 22 formée par une couche superficielle de borure ou de boronitrure de métal de transition est portée par un substrat suffisamment rigide pour permettre une résistance aux chocs ainsi qu'une résistance à la microrayure et/ou à l'abrasion satisfaisante.

La présente invention n'est nullement limitée aux exemples de réalisation décrits, mais englobe de nombreuses modifications dans le cadre des revendications.

## Revendications

1. Semelle (1) de fer à repasser comportant un corps de semelle (11 ; 21) métallique présentant une surface de glisse (12; 22) céramique prévue pour le repassage, **caractérisée en ce que** le corps de semelle (11 ; 21) présente une dureté supérieure ou égale à 150 HV et forme un substrat portant une couche superficielle de borure de métal de transition ou de boronitrure de métal de transition formant la surface de glisse (12 ; 22).

2. Semelle (1) de fer à repasser selon la revendication 1, **caractérisée en ce que** le corps de semelle (11 ; 21) présente un coefficient de dilatation thermique inférieur à 20.10⁻⁶ K⁻¹.

3. Semelle (1) de fer à repasser selon l'une des revendications 1 ou 2, **caractérisée en ce que** le corps de semelle (11 ; 21) est réalisé en acier inoxydable ou en titane.

4. Semelle (1) de fer à repasser selon l'une des revendications 1 à 3, **caractérisée en ce que** la couche superficielle est formée par un revêtement de borure de métal de transition ou de boronitrure de métal de transition.

5. Semelle (1) de fer à repasser selon la revendication 4, **caractérisée en ce que** le métal de transition est choisi parmi le titane, le chrome, le zirconium, le vanadium, le niobium, le fer.

6. Semelle (1) de fer à repasser selon l'une des revendications 1 ou 2, **caractérisée en ce que** la couche superficielle est formée par une couche de conversion de borure de fer et/ou de titane.

7. Fer à repasser, comportant une semelle (1) associée à un corps de chauffe (4) comprenant des moyens électriques de chauffe (5), **caractérisé en ce que** la semelle (1) est conforme à l'une des revendications 1 à 6.

8. Fer à repasser selon la revendication 7, **caractérisé en ce que** la semelle (1) comporte des orifices (3) prévus pour le passage de vapeur.

9. Fer à repasser selon la revendication 8, **caractérisé en ce qu'**il comporte un générateur de vapeur interne (6) relié aux orifices (3) prévus pour le passage de la vapeur.

10. Fer à repasser selon la revendication 8, **caractérisé en ce qu'**il est associé à un générateur de vapeur externe (7) relié aux orifices (3) prévus pour le passage de la vapeur.

11. Procédé d'obtention d'une semelle (1) de fer à repasser, comprenant les étapes suivantes :
- fourniture ou réalisation d'un corps de semelle (11 ; 21) métallique présentant une dureté supérieure ou égale à 150 HV,
- réalisation d'une couche superficielle de borure de métal de transition ou de boronitrure de métal de transition sur la face externe du corps de semelle (11 ; 21), pour former une surface de glisse (12 ; 22).

12. Procédé d'obtention d'une semelle (1) de fer à repasser selon la revendication 11, **caractérisé en ce que** le corps de semelle (11 ; 21) présente un coefficient de dilatation thermique inférieur à 20.10⁻⁶ K⁻¹.

13. Procédé d'obtention d'une semelle (1) de fer à repasser selon l'une des revendications 11 ou 12, **caractérisé en ce que** le corps de semelle (11 ; 21) est réalisé en acier inoxydable ou en titane.

14. Procédé d'obtention d'une semelle (1) de fer à repasser selon l'une des revendications 11 à 13, **caractérisé en ce qu'**il consiste à réaliser un revêtement de borure de métal de transition ou de boronitrure de métal de transition sur la face externe du corps de semelle (11).

15. Procédé d'obtention d'une semelle (1) de fer à repasser selon la revendication 14, **caractérisé en ce que** le métal de transition est choisi parmi le titane, le chrome, le zirconium, le vanadium, le niobium, le fer.

16. Procédé d'obtention d'une semelle (1) de fer à repasser selon l'une des revendications 14 ou 15, **caractérisé en ce que** le revêtement est réalisé par dépôt physique en phase vapeur sur la face externe du corps de semelle (11).

17. Procédé d'obtention d'une semelle (1) de fer à repasser selon la revendication 16, **caractérisé en ce que** le dépôt est réalisé par pulvérisation cathodique magnétron à courant continu, de préférence à courant continu puisé.

18. Procédé d'obtention d'une semelle (1) de fer à repasser selon l'une des revendications 14 ou 15, **caractérisé en ce que** le revêtement est réalisé par dépôt chimique en phase vapeur assistée plasma sur la face externe du corps de semelle (11).

19. Procédé d'obtention d'une semelle (1) de fer à repasser selon l'une des revendications 11 à 13, **caractérisé en ce qu'**il consiste à réaliser une couche de conversion de borure de fer ou de titane par traitement de diffusion thermochimique de boruration sur la face externe du corps de semelle (21).

## Patentansprüche

1. Bügeleisensohle (1) mit einem Metall-Sohlenkörper (11; 21), der eine für das Bügeln vorgesehene Keramik-Gleitfläche (12; 22) aufweist, **dadurch gekennzeichnet dass** der Sohlenkörper (11;21) eine Härte von mindestens 150 HV hat und ein Substrat bildet, das eine Oberflächenschicht aus dem Borid eines Übergangsmetalls oder dem Bornitrid eines Übergangsmetalls trägt, die die Gleitfläche (12; 22) bildet.

2. Bügeleisensohle (1) nach Anspruch 1, **dadurch gekennzeichnet, dass** der Sohlenkörper (11; 21) einen Wärmeausdehnungskoeffizienten von unter 20·10⁻⁶ K⁻¹ aufweist.

3. Bügeleisensohle (1) nach einem der Ansprüche 1 oder 2, **dadurch gekennzeichnet, dass** der Sohlenkörper (11; 21) aus Edelstahl oder Titan hergestellt wird.

4. Bügeleisensohle (1) nach einem der Ansprüche 1 bis 3, **dadurch gekennzeichnet, dass** die Oberflächenschicht durch eine Beschichtung mit dem Borid eines Übergangsmetalls oder dem Bornitrid eines Übergangsmetalls gebildet wird.

5. Bügeleisensohle (1) nach Anspruch 4, **dadurch gekennzeichnet, dass** das Übergangsmetall aus Titan, Chrom, Zirkonium, Vanadium, Niobium und Eisen ausgewählt wird.

6. Bügeleisensohle (1) nach einem der Ansprüche 1 oder 2, **dadurch gekennzeichnet, dass** die Oberflächenschicht durch eine Konversionsschicht aus Eisen- und/oder Titanborid gebildet wird.

7. Bügeleisen mit einer Sohle (1), die zu einem Heizelement (4) gehört, das elektrische Heizmittel (5) umfasst, **dadurch gekennzeichnet, dass** die Sohle (1) einem der Ansprüche 1 bis 6 entspricht.

8. Bügeleisen nach Anspruch 7, **dadurch gekennzeichnet, dass** die Sohle (1) Öffnungen (3) für den Durchtritt von Dampf aufweist.

9. Bügeleisen nach Anspruch 8, **dadurch gekennzeichnet, dass** es einen internen Dampfgenerator (6) aufweist, der mit den Öffnungen (3) für den Durchtritt des Dampfes verbunden ist.

10. Bügeleisen nach Anspruch 8, **dadurch gekennzeichnet, dass** es zu einem externen Dampfgenerator (7) gehört, der mit den Öffnungen (3) für den Durchtritt des Dampfes verbunden ist.

11. Verfahren zur Herstellung einer Bügeleisensohle (1), das die folgenden Schritte umfasst:
- Bereitstellung oder Herstellung eines Metall-Sohlenkörpers (11; 21) mit einer Härte von mindestens 150 HV,
- Aufbringen einer Oberflächenschicht aus dem Borid eines Übergangsmetalls oder dem Bornitrid eines Übergangsmetalls auf der Außenseite des Sohlenkörpers (11; 21), um eine Gleitfläche (12; 22) zu bilden.

12. Verfahren zur Herstellung einer Bügeleisensohle (1) nach Anspruch 11, **dadurch gekennzeichnet, dass** der Sohlenkörper (11; 21) einen Wärmeausdehnungskoeffizienten von unter 20·10⁻⁶ K⁻¹ aufweist.

13. Verfahren zur Herstellung einer Bügeleisensohle (1) nach einem der Ansprüche 11 oder 12, **dadurch gekennzeichnet, dass** der Sohlenkörper (11; 21) aus Edelstahl oder Titan hergestellt wird.

14. Verfahren zur Herstellung einer Bügeleisensohle (1) nach einem der Ansprüche 11 bis 13, **dadurch gekennzeichnet, dass** es darin besteht, auf der Außenseite des Sohlenkörpers (11) eine Beschichtung aus dem Borid eines Übergangsmetalls oder dem Bornitrid eines Übergangsmetalls aufzubringen.

15. Verfahren zur Herstellung einer Bügeleisensohle (1) nach Anspruch 14, **dadurch gekennzeichnet, dass** das Übergangsmetall aus Titan, Chrom, Zirkonium, Vanadium, Niobium und Eisen ausgewählt wird.

16. Verfahren zur Herstellung einer Bügeleisensohle (1) nach einem der Ansprüche 14 oder 15, **dadurch gekennzeichnet, dass** die Beschichtung durch physikalische Gasphasenabscheidung auf der Außenseite des Sohlenkörpers (11) erfolgt.

17. Verfahren zur Herstellung einer Bügeleisensohle (1) nach Anspruch 16, **dadurch gekennzeichnet, dass** die Abscheidung durch Magnetron-Kathodenzerstäubung mit Gleichstrom, vorzugsweise pulsierendem Gleichstrom, erfolgt.

18. Verfahren zur Herstellung einer Bügeleisensohle (1) nach einem der Ansprüche 14 oder 15, **dadurch gekennzeichnet, dass** die Beschichtung durch plasmaunterstützte chemische Gasphasenabscheidung auf der Außenseite des Sohlenkörpers (11) erfolgt.

19. Verfahren zur Herstellung einer Bügeleisensohle (1) nach einem der Ansprüche 11 bis 13, **dadurch gekennzeichnet, dass** es darin besteht, durch eine thermochemische Diffusionsbehandlung des Borierens auf der Außenseite des Sohlenkörpers (21) eine Konversionsschicht aus Eisen- oder Titanborid aufzubringen.

## Claims

1. Iron sole (1) having a metallic sole body (11; 21) with a ceramic sliding surface (12; 22) intended for ironing, **characterised in that** the sole body (11; 21) has a hardness greater than or equal to 150 HV and forms a substrate having a surface layer of transition metal boride or transition metal boronitride forming the sliding surface (12; 22).

2. Iron sole (1) according to claim 1, **characterised in that** the sole body (11; 21) has a coefficient of thermal expansion less than 20.10⁻⁶ K⁻¹.

3. Iron sole (1) according to claim 1 or 2, **characterised in that** the sole body (11; 21) is made of stainless steel or titanium.

4. Iron sole (1) according to one of claims 1 to 3, **characterised in that** the surface layer is formed by a coating of transition metal boride or transition metal boronitride.

5. Iron sole (1) according to claim 4, **characterised in that** the transition metal is chosen from titanium, chromium, zirconium, vanadium, niobium and iron.

6. Iron sole (1) according to claim 1 or 2, **characterised in that** the surface layer is formed by a conversion layer of iron and/or titanium boride.

7. Iron having a sole (1) associated with a heating body (4) comprising electrical heating means (5), **characterised in that** the sole (1) complies to one of claims 1 to 6.

8. Iron according to claim 7, **characterised in that** the sole (1) comprises holes (3) designed for the passage of steam.

9. Iron according to claim 8, **characterised in that** it comprises an internal steam generator (6) connected to the holes (3) designed for the passage of steam.

10. Iron according to claim 8, **characterised in that** it is associated with an external steam generator (7) connected to the holes (3) designed for the passage of steam.

11. Method of obtaining an iron sole (1), comprising the following steps:
- supply or manufacture of a metallic sole body (11; 21) having a hardness greater than or equal to 150 HV,
- manufacture of a surface layer of transition metal boride or transition metal boronitride on the outer surface of the sole body (11; 21), to form a sliding surface (12; 22).

12. Method of obtaining an iron sole (1) according to claim 11, **characterised in that** the sole body (11; 21) has a coefficient of thermal expansion less than 20.10⁻⁶ K⁻¹.

13. Method of obtaining an iron sole (1) according to claim 11 or 12, **characterised in that** the sole body (11; 21) is made of stainless steel or titanium.

14. Method of obtaining an iron sole (1) according to one of claims 11 to 13, **characterised in that** it consists in producing a coating of transition metal boride or transition metal boronitride on the outer surface of the sole body (11).

15. Method of obtaining an iron sole (1) according to claim 14, **characterised in that** the transition metal is chosen from titanium, chromium, zirconium, vanadium, niobium and iron.

16. Method of obtaining an iron sole (1) according to claim 14 or 15, **characterised in that** the coating is produced by physical steam deposition on the outer surface of the sole body (11).

17. Method of obtaining an iron sole (1) according to claim 16, **characterised in that** the deposit is produced by direct current magnetron cathode sputtering, preferably pulsed direct current.

18. Method of obtaining an iron sole (1) according to claim 14 or 15, **characterised in that** the coating is produced by plasma assisted chemical steam deposition on the outer surface of the sole body (11).

19. Method of obtaining an iron sole (1) according to one of claims 11 to 13, **characterised in that** it consists of producing a conversion layer of iron or titanium boride by boriding thermochemical diffusion treatment on the outer surface of the sole body (21).
